Europäisches Patentamt

European Patent Office

Office européen des brevets

(11) Veröffentlichungsnummer: **0 375 880 B1**

(12) **EUROPÄISCHE PATENTSCHRIFT**

(45) Veröffentlichungstag der Patentschrift: **22.06.94**

(51) Int. Cl.5: **H03B  23/00**, G06F 7/68

(21) Anmeldenummer: **89119982.0**

(22) Anmeldetag: **27.10.89**

(54) **Frequenzsynthesegerät.**

(30) Priorität: **23.12.88 CH 4781/88**

(43) Veröffentlichungstag der Anmeldung:
**04.07.90 Patentblatt  90/27**

(45) Bekanntmachung des Hinweises auf die
Patenterteilung:
**22.06.94 Patentblatt  94/25**

(84) Benannte Vertragsstaaten:
**CH DE FR GB IT LI NL SE**

(56) Entgegenhaltungen:
**EP-A- 0 078 588**
**US-A- 3 696 306**
**US-A- 3 772 681**
**US-A- 3 831 015**

(73) Patentinhaber: **SIEMENS-ALBIS AKTIENGE-**
**SELLSCHAFT**
**PV/Patente und Verträge**
**Postfach**
**CH-8047 Zürich(CH)**

(72) Erfinder: **Lauper, Alfred**
**Wydäckerring 69**
**CH-8047 Zürich(CH)**
Erfinder: **Küpfer, Hanspeter**
**Stöckenstrasse 46**
**CH-8903 Birmensdorf(CH)**
Erfinder: **Rieder, Daniel**
**Am Wasser 18**
**CH-8903 Birmensdorf(CH)**

## Beschreibung

Die vorliegende Erfindung betrifft ein Frequenzsynthesegerät nach dem Oberbegriff des Patentanspruches 1.

In Funk- und Radartechnik werden Sender eingesetzt, deren Sendefrequenz sprunghaft geändert werden kann. Durch einen schnellen Frequenzwechsel können z.B. leistungsstarke, schmalbandige Störsender umgangen werden. Um ein möglichst störungsfreies Nutzsignal zu erhalten, sollten dabei die beim Empfänger eintreffenden Signale phasenkohärent demoduliert werden. Die Voraussetzung für eine phasenkohärente Demodulation ist, dass die Phasenlage der Sendesignale und der dem Demodulator zugeführten Referenzsignale nach jedem Frequenzwechsel wieder je einen vorbestimmten Wert annimmt.

Aus der US-Patentschrift No. 3,696,306 ist ein phasenkohärentes Frequenzsynthesegerät bekannt, das eine elektrische Schwingung erzeugen kann, deren Phasenlage nach schnellen, sprunghaften Frequenzänderungen immer einen vorbestimmten Wert annimmt. Nachteile bei dieser in Analogtechnik aufgebauten Schaltung sind der hohe Schaltungsaufwand und eine relativ hohe Umschaltzeit für einen Frequenzwechsel. Zudem ist ein kleiner Linienabstand für das resultierende Frequenzraster nur mit zusätzlichem hohen Schaltungsaufwand zu realisieren.

In der Zeitschrift "RF Design" (1987) 5 wird im Artikel "Direct Numerical Synthesis of Sine Waves" von Fred Williams der Aufbau eines direkten digitalen Frequenzsynthesegerätes (DDS) beschrieben, das die Erzeugung von elektrischen Schwingungen im Zeitbereich ermöglicht. Dieses digitale Frequenzsynthesegerät weist einen einfachen Schaltungsaufbau auf, der mit wenigen integrierten Bauteilen realisiert werden kann. Das Umschalten der Frequenz erfolgt digitalen Frequenzsynthesegerät jedoch phasenkontinuierlich, d.h. der Endwert der Phase $\Phi_A$ der früher erzeugten Frequenz $f_A$ ist gleich dem Anfangswert der Phase $\Phi_N$ der neu erzeugten Frequenz $f_N$.

Der vorliegenden Erfindung liegt daher die Aufgabe zugrunde, diese Schaltung zu verbessern. Diese Aufgabe wird durch die im kennzeichnenden Teil des Patentanspruches 1 angegebenen Massnahmen gelöst. Vorteilhafte Ausgestaltungen der Erfindung sind in weiteren Ansprüchen angegeben.

Wichtigste Vorteile des erfindungsgemässen Frequenzsynthesegerätes sind der einfache digitale Schaltungsaufbau und die Möglichkeit, schnelle phasenkohärente Frequenzwechsel auch bei keinem Linienabstand des Frequenzrasters durchzuführen.

Die Erfindung wird nachfolgend anhand einer Zeichnung beispielsweise näher erläutert. Es zeigt

:

| Fig.1 | den Aufbau eines bekannten direkten digitalen Frequenzsynthesegerätes (DDS) |
| Fig.2 | den Aufbau eines erfindungsgemässen Frequenzsynthesegerätes |
| Fig.3 | zwei Möglichkeiten für den zeitlichen Ablauf eines Frequenzwechsels |

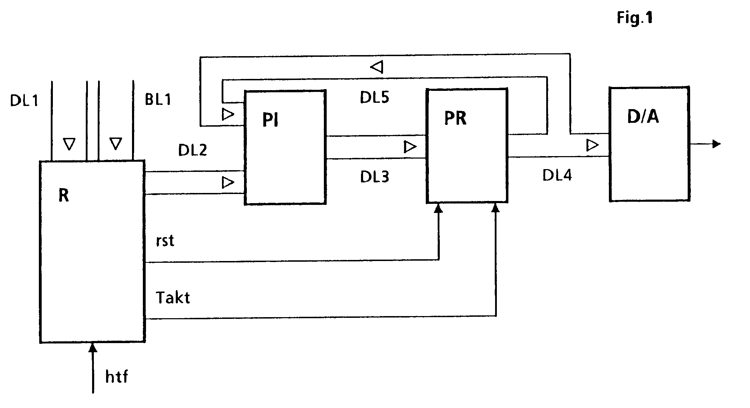

Das bekannte Frequenzsynthesegerät nach Fig. 1 weist eine Phaseninkrementierstufe PI und eine Phasenregisterstufe PR auf, die zu einem Phasenakkumulator zusammengeschaltet sind, der mit einem Rechenwerk R und einem Analog-Digital-Wandler D/A verbunden ist.

Dem Rechenwerk R wird eine Haupttaktfrequenz htf und über eine parallele Datenleitung DL1 der Wert einer neu zu erzeugenden Frequenz $f_N$ eingegeben. Der Befehl zum Einlesen der anliegenden Daten und zum Ändern der Frequenz wird dem Rechenwerk über die Befehlsleitung BL1 zugeführt. Für die neu eingegebene Frequenz $f_N$ berechnet das Rechenwerk R die Phasenänderung $\Delta\Phi_N$, welche einer Zeitspanne $t_p$ entspricht ($\Delta\Phi_N = 2\pi\ f_N \times t_p$). In der Phaseninkrementierstufe PI wird der Inhalt der Phasenregisterstufe PR, der der Phaseninkrementierstufe PI über eine Datenleitung DL5 zugeführt wird, periodisch mit einem über eine Datenleitung DL2 zugeführten, der berechneten Phasenänderung $\Delta\Phi_N$ entsprechenden Wert addiert bzw. inkrementiert und über eine Datenleitung DL3 dem Eingang der Phasenregisterstufe PR zugeführt. Die Dauer dieses periodischen Vorganges wird durch die der Phasenregisterstufe PR zugeführten Taktfrequenz bestimmt und entspricht dabei der Zeitspanne $t_p$. Der Inhalt der Phasenregisterstufe PR wird weiter über eine Datenleitung DL4 dem Digital-Analog-Wandler D/A zugeführt, der ein Signal mit der Frequenz $f_N$ ($f_N = \Delta\Phi_N/2\pi\ t_p$) abgibt. Damit die abzugebende Frequenz eindeutig bestimmt ist, sollen mindestens zwei Registerwerte pro Periode der abgegebenen Frequenz dem Digital-Analog-Wandler D/A zugeführt werden. Ein Durchlauf der Phasenregisterstufe PR entspricht dabei einer Periode der abgegebenen Schwingung. Die Anfangsphase $\Phi_N$ einer neuen Frequenz $f_N$ entspricht bei dieser Einrichtung jeweils dem zufällig vorhandenen Inhalt der Phasenregisterstufe PR, d.h. die Phase der alten Schwingung geht nahezu kontinuierlich in die Phase der neuen Schwingung über.

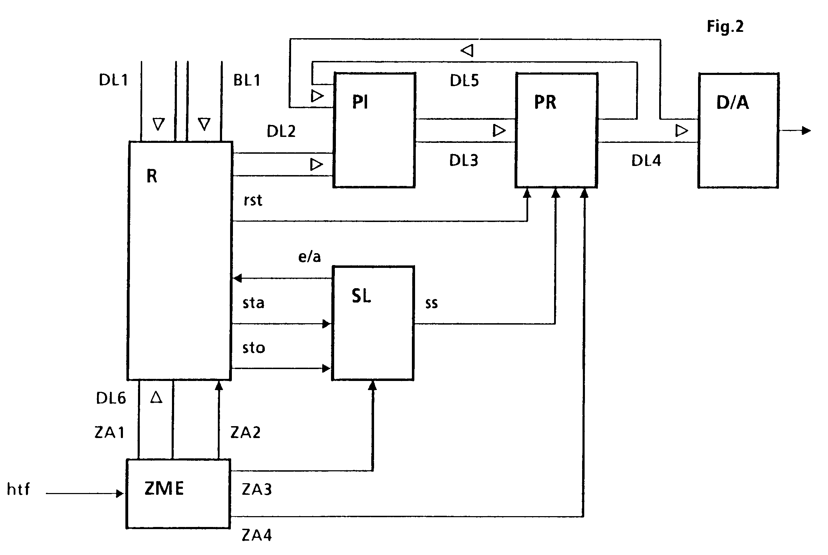

Das erfindungsgemässe Frequenzsynthesegerät nach Fig. 2 weist zusätzlich zur Schaltung gemäss Fig. 1 eine Zeitmesseinheit ZME und eine Steuerlogik SL auf. Der Zeitmesseinheit ZME mit vier Ausgängen ZA1, ZA2, ZA3 und ZA4 wird über den Eingang ZE1 eine Haupttaktfrequenz htf eingegeben, von der im Frequenzsynthesegerät alle Takt- und Zeitsignale abgeleitet werden. Die Ausgänge ZA1 und ZA2 der Zeitmesseinheit ZME, die über eine parallele Datenleitung DL6 ein Zeitsignal und über eine weitere Leitung ein Taktsignal abgeben, sind mit dem Rechenwerk R verbunden. Vom Ausgang ZA3 der Zeitmesseinheit ZME werden periodisch Zeitmarken ZM an die Steuerlogik SL abgegeben. Vom Ausgang ZA4 der Zeitmesseinheit ZME führt eine Taktleitung zur Phasenregisterstufe PR. Das Rechenwerk R ist durch zwei Befehlsleitungen sta (Inkrementstart) bzw. sto (Inkrementstop) mit der Steuerlogik SL und über eine Resetleitung rst mit der Phasenregisterstufe PR verbunden. Von der Steuerlogik SL führt eine Leitung ss (Inkrementstart /- stop) zur Phasenregisterstufe PR. Eine Statusleitung e/a die anzeigt, zu welchem Zählzeitpunkt $t = t_A$ der Inkrementiervorgang angehalten wird, führt von der Steuerlogik SL zum Rechenwerk R.

Die Zeitmesseinheit ZME zählt periodisch eine Zeitspanne von $t = 0$ bis $t = t_Z$ ab und gibt den aktuellen Zählerstand über den Zählerausgang ZA1 an das Rechenwerk R weiter. Die Zeitspanne von $t = 0$ bis $t = t_Z$ und die möglichen zu erzeugenden Frequenzen $f_i$ sind derart festgelegt, dass die Zeitspanne von $t = 0$ bis $t = t_Z$ jeweils einem ganzzahligen Vielfachen der Periodendauer aller erzeugbaren Frequenzen $f_i$ entspricht. Damit wird erreicht, dass die Phasen $\Phi_i$ aller möglichen erzeugbaren Frequenzen fi für die Zählzeitpunkte $t = 0$ einen unveränderten Wert annehmen, was die Ermittlung eines kohärenten Phasenwertes $\Phi_N$ für eine Frequenz $f_N$ für einen späteren Zählzeitpunkt $t_N$ ($\Phi_N = |2\pi\ f_N\ x\ t_N + \Phi_0\ |\ mod\ 2\pi$) auch nach mehrmaligem Umschalten der Frequenz und Überschreiten des Zählzeitpunktes $t_Z$ ermöglicht. Der Wert für den Phasenwinkel $\Phi_0$ muss für alle Berechnungen des Anfangsphasenwinkels $\Phi_N$ gleich sein und und ist normalerweise gleich null.

Der resultierende minimale Linienabstand $\Delta f_{min}$ des abzugebenden Frequenzrasters kann wie folgt ermittelt werden :
für eine erste Frequenz f1 gilt : m x $1/f_1$ = $t_Z$ bzw. $f_1 = m/t_Z$,
für die nächsthöhere Frequenz f2 = f1 + $\Delta f_{min}$ gilt : (m + 1) x $1/f_2$ = $t_Z$ bzw. (m + 1) = (f1 + $\Delta f_{min}$) x $t_Z$ = (m/$t_Z$ + $\Delta f_{min}$) x $t_Z$ = m + $\Delta f_{min}$ x $t_Z$ bzw. 1 = $\Delta f_{min}$ x $t_Z$ Folglich entspricht der minimale Linienabstand $\Delta f_{min}$ dem Kehrwert der Zeitspanne von $t = 0$ bis $t = t_Z$ ($\Delta fmin$ = $1/t_Z$). Durch das Vergrössern der Zeitspanne von $t = 0$ bis $t = t_Z$ kann somit ein beliebig enger Linienabstand des Frequenzrasters erzielt werden. Falls die Zeitspanne von $t = 0$ bis $t = t_Z$ nie überschritten wird, können beliebige Frequenzen phasenkohärent erzeugt werden.

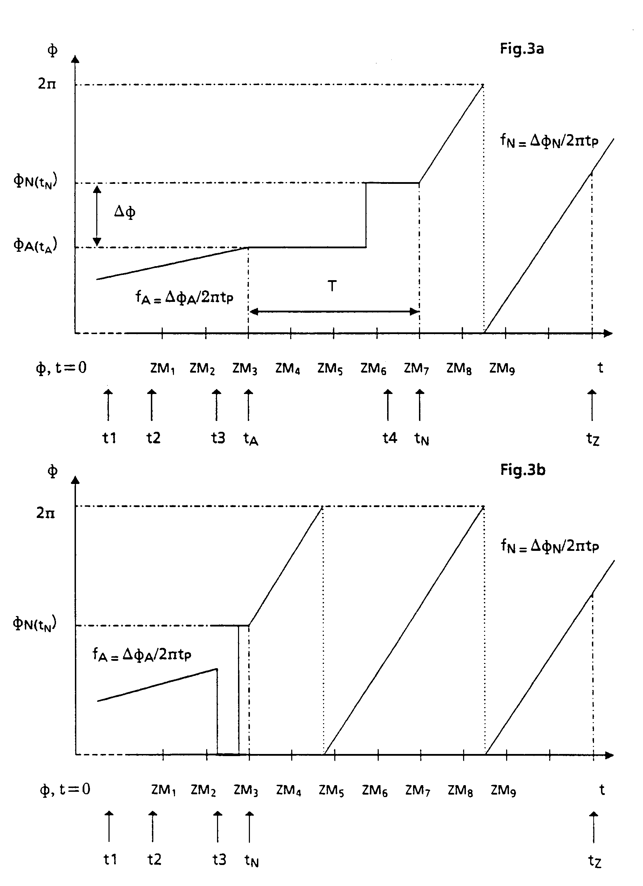

Der Ablauf eines Frequenzwechsels wird nachfolgend anhand der Zeitdiagramme von Fig. 3 näher erläutert.

Gemäss Fig. 3a wird zum Zeitpunkt t1 eine neue Frequenz $f_N$ ins Rechenwerk R eingelesen und abgespeichert. Zum Zeitpunkt t2 geht der Befehl ans Rechenwerk R, die gegenwärtig generierte Frequenz $f_A$ durch die neue Frequenz $f_N$ zu ersetzen. Zum Zeitpunkt t3 sendet das Rechenwerk R einen Inkrementierstop-Befehl sto an die Steuerlogik SL, welche beim Eintreffen der nächsten Zeitmarke $ZM_3$ bzw. zum Zählzeitpunkt $t_A$ den Inkrementiervorgang über die Leitung ss (Inkrementstart /- stop) anhält. Das Anhalten des Inkrementiervorganges wird dem Rechenwerk R über die Statusleitung e/a mitgeteilt. Das Rechenwerk R berechnet nun den Zählzeitpunkt $t_N$ ($t_N = t_A + T$; die Zeitspanne T ist eine konstante Verzögerung und entspricht vorteilhafterweise dem ganzzahligen Vielfachen des Abstandes zwischen zwei Zeitmarken ZM), die zukünftigen Phaseninkremente $\Delta\Phi_N = 2\pi\ f_N\ x\ t_p$, den Wert der Phase $\Phi_A$ zum Zählzeitpunkt

$$t_A\ (\phi_{A(t_A)}\ =\ 2\pi\ f_A\ x\ t_A)$$

und den Wert der Phase $\Phi_N$ für den Zählzeitpunkt

$$t_N\ (\ \phi_{N\ (t_N)}\ =\ 2\pi\ f_N\ x\ t_N).$$

Die Zeitspanne T (T = $t_N$ - $t_A$) ist eine konstante Verzögerung, die vom Anhalten der alten Frequenz $f_A$ bis zum Erzeugen der neuen Frequenz $f_N$ für Rechen- und Steuervorgänge benötigt wird. Weiter wird vom Rechenwerk R die Phasendifferenz

$$\Delta\phi\ =\ \phi_{N(t_N)}\ -\ \phi_{A(t_A)}$$

berechnet und zum Inhalt der Phasenregisterstufe PR addiert bzw. inkrementiert.

Nach Ablauf der Verzögerungszeit T wird im Zählzeitpunkt $t_N$, der im vorliegenden Beispiel mit der Zeitmarke $ZM_7$ zusammenfällt, der Inkrementiervorgang wieder gestartet. Das Rechenwerk R sendet zu diesem Zweck zum Zeitpunkt t4, kurz vor dem Eintreffen der Zeitmarke $ZM_7$, einen Inkrementstart-Befehl über die Leitung sta an die Steuerlogik SL, welche beim Eintreffen der Zeitmarke $ZM_7$ den Inkrementiervorgang über die Leitung ss startet. Die neue Frequenz $f_N$ wird folglich ab dem Zeitpunkt $t_N$ mit der Anfangsphase $\Phi_N$ erzeugt. Anschliessend wird die alte Frequenz $f_A$ im Speicher des Rechenwerkes R durch die neue, schon gestartete Frequenz $f_N$ ersetzt, so dass das Frequenzsynthesegerät für einen neuen, phasenkohärenten Frequenzwechsel bereitsteht. Anstatt die Phasenwerte $\Phi_A$ für den Zählzeitpunkt $t_A$ jeweils zu berechnen, könnte nach dem Anhalten des Inkrementiervorganges der Inhalt der Phasenregisterstufe PR auch über eine zusätzliche Datenleitung ins Rechenwerk R eingelesen werden.

Die Zeitmarken ZM, welche die Zeitmesseinheit ZME periodisch an die Steuerlogik SL abgibt, vereinfachen folglich den Ablauf des Frequenzwechsels, da sich der Zählzeitpunkt $t_A$, die konstante Verzögerungszeit T und damit der Zählzeitpunkt $t_N$ einfacher festlegen bzw. berechnen lassen.

Eine vereinfachte Möglichkeit zu einem Frequenzwechsel mit verkürzter Umschaltzeit wird anhand von Fig. 3b aufgezeigt. Zum Zeitpunkt t1 wird eine neue Frequenz $f_N$ ins Rechenwerk R eingelesen und abgespeichert. Das Rechenwerk R berechnet anschliessend die zukünftigen Phaseninkremente $\Delta\Phi_N$. Zum Zeitpunkt t2 geht der Befehl ans Rechenwerk R, die gegenwärtig generierte Frequenz $f_A$ durch die neue Frequenz $f_N$ zu ersetzen. Das Rechenwerk berechnet in der Folge einen zukünftigen Zählzeitpunkt $t_N$ ; z.B. derart, dass der Zähzeitpunkt $t_N$ mit der folgenden dritten Zeitmarke $ZM_3$ zusammenfällt. In der Folge berechnet das Rechenwerk R mittels der Werte $t_N$ und $f_N$ die Anfangsphase

$$\Phi_{N(t_N)}$$

für den Zählzeitpunkt $t_N$. Nachdem dieser Wert ermittelt wurde , wird zum Zeitpunkt t3 der Inkrementiervorgang angehalten und die Phasenregisterstufe PR auf Null zurückgesetzt. Dann wird die Phasenregisterstufe PR um den Wert der berechneten Anfangsphase

$$\Phi_{N(t_N)}$$

inkrementiert. Zum Zählzeitpunkt $t_N$ wird der Inkrementiervorgang mit den im voraus berechnete Inkrementen $\Delta\Phi_N$ wieder gestartet.

**Patentansprüche**

1. Verfahren zum Erzeugen von periodischen elektrischen Schwingungen mit wahlweise einstellbarer Frequenz, wobei nach Verändern und Rückstellen der Frequenz auf jeden beliebigen früher bereits erzeugten Wert die Phasenkohärenz erhalten bleibt, **dadurch gekennzeichnet,** dass periodisch eine Zeitspanne von t = 0 bis t = $t_Z$ abgezählt wird, und dass die Anfangsphase $\Phi_N$ einer neu einzustellenden Frequenz $f_N$ im voraus für einen späteren, einem Stand der periodisch abgezählten Zeitspanne entsprechenden Zählzeitpunkt $t_N$ (0 $\leq t_N \leq t_Z$) berechnet und die Frequenz $f_N$ vom Zählzeitpunkt $t_N$ mit der Anfangsphase $\Phi_N$ erzeugt wird.

2. Verfahren nach Anspruch 1, dadurch gekennzeichnet, dass die Anfangsphase $\Phi_N$ anhand der Formel $\Phi_N = |2\pi\ f_N\ t_N\ +\ \Phi_0|$ modulo $2\pi$ berechnet wird, wobei die Phase $\Phi_0$ für alle neu zu erzeugenden Frequenzen $f_N$ gleich ist.

3. Verfahren nach Anspruch 2, dadurch gekennzeichnet, dass zum Erzeugen beliebiger Frequenzen $f_N$ die abzuzählende Zeitspanne von t = 0 bis t = $t_Z$ derart gewählt wird, dass der letzte Frequenzwechsel vor dem erstmaligen Überschreiten des Zählzeitpunkts $t_Z$ erfolgt.

4. Verfahren nach Anspruch 2, **dadurch gekennzeichnet,** dass nach dem erstmaligen Überschreiten des Zählzeitpunkts $t_Z$ nur noch Frequenzen mit einer Periodendauer, deren ganzzahliges Vielfaches der Zeitspanne von t = 0 bis t = $t_Z$ entspricht, erzeugt werden.

5. Verfahren nach Anspruch 3 oder 4, **dadurch gekennzeichnet,** dass vor der Erzeugung einer Schwingung mit einer neuen Frequenz $f_N$ die Erzeugung der alten Schwingung mit der alten Frequenz $f_A$ zu einem Zählzeitpunkt $t_A$ (0 $\leq t_A \leq t_Z$) abgebrochen wird.

6. Verfahren nach einem der vorhergehenden Ansprüche, **dadurch gekennzeichnet,** dass periodisch Zeitmarken (ZM) erzeugt werden, durch die verschiedene Zählzeitpunkte (z.B. t = 0, $t_Z$, $t_A$ und / oder $t_N$) festgelegt werden, wobei der Zählzeitpunkt $t_A$ auf eine Zeitmarke ($ZM_1$) und der Zählzeitpunkt $t_N$ auf eine der folgenden Zeitmarken ($ZM_{(1+x)}$) fällt.

7. Verfahren nach einem der vorhergehenden Ansprüche, **dadurch gekennzeichnet,** dass die Phase $\Phi_i$ einer Frequenz $f_i$ dem periodisch inkrementierten Inhalt einer Phasenregisterstufe PR entspricht, dass nach einem Frequenzwechselbefehl der Inkrementiervorgang zum Zählzeitpunkt $t_A$ angehalten wird, dass die Phase $\Phi_A$ der alten Frequenz $f_A$ für den Zählzeitpunkt $t_A$ berechnet oder aus dem Phasenregister (PR) ausgelesen wird, und dass die Phase $\Phi_N$ der neuen Frequenz $f_N$ für den später folgenden Zählzeitpunkt $t_N$ und daraus die Phasendifferenz

$$\Delta\phi\ =\ \Phi_{N(t_N)}\ -\ \Phi_{A(t_A)}$$

berechnet und danach zu einem Zählzeitpunkt $t_R$ ($t_A \leq t_R \leq t_N$) zum Inhalt der Phasenregisterstufe (PR) addiert wird oder dass der Inhalt der Phasenregisterstufe (PR) zu einem Zählzeitpunkt $t_R$ ($t_A \leq t_R \leq t_N$) auf Null gesetzt und um den Betrag der berechneten Phase $\Phi_N$ erhöht wird, und dass der Inkrementiervorgang zum Zählzeitpunkt $t_N$ wieder gestartet wird.

8. Verfahren nach Anspruch 7, **dadurch gekennzeichnet,** dass das periodische Abzählen der Zeitspanne von $t = 0$ bis $t = t_Z$ und der Inkrementiervorgang der Phasenregisterstufe (PR) sowie, falls vorhanden, die Zeitmarken (ZM) durch denselben Haupttakt zeitlich gesteuert werden.

9. Direkt digitales Frequenzsynthesegerät zur Durchführung des Verfahrens nach Anspruch 1 mit einer Haupttaktfrequenz (htf) und einem aus einer Phaseninkrementierstufe (PI) und einer Phasenregisterstufe (PR) gebildeten Phasenakkumulator, der ein digitales Ausgangssignal abgibt, **dadurch gekennzeichnet,** dass ein über Steuer- und Datenleitungen mit dem Phasenakkumulator und mit einer Zeitmesseinheit (ZME) verbundener Rechner (R) vorgesehen ist, der die Anfangsphase $\Phi_N$ einer neu einzustellenden Frequenz $f_N$ für einen Zeitpunkt $t_N$ berechnet, den ermittelten Wert in den Phasenakkumulator ablegt und den Frequenzsynthesevorgang zum Zeitpunkt $t_N$ für die Frequenz $f_N$ beginnend mit der berechneten und abgespeicherten Anfangsphase $\Phi_N$ auslöst.

10. Direkt digitales Frequenzsynthesegerät nach Anspruch 9, **dadurch gekennzeichnet,** dass der Rechner (R) zur Berechnung der Phasendifferenz $\Delta\Phi$ zwischen der im Akkumulator vorhandenen Phase $\Phi_A$ und der Anfangsphase $\Phi_N$ sowie zu deren Abgabe an den Akkumulator vorgesehen ist.

11. Direkt digitales Frequenzsynthesegerät nach Anspruch 9, **dadurch gekennzeichnet,** dass der Rechner (R) zur Rücksetzung des Akkumulators und zur Eingabe der Anfangsphase $\Phi_N$ in den Akkumulator vorgesehen ist.

12. Direkt digitales Frequenzsynthesegerät nach Anspruch 10 oder 11, **dadurch gekennzeichnet,** dass der Rechner (R) zum Anhalten des Akkumulators zu einem Zeitpunkt $t_A$ und zum Neustart des Akkumulators zu einem Zeitpunkt $t_N$ vorgesehen ist.

13. Direkt digitales Frequenzsynthesegerät nach einem der vorhergehenden Ansprüche 9 bis 12, **dadurch gekennzeichnet,** dass von den Ausgängen (ZA1, ZA2, ZA3, ZA4) der Zeitmesseinheit (ZME) von der Haupttaktfrequenz (htf) abgeleitete Signale abgegeben werden, dass von den Ausgängen (ZA1) und (ZA2) ein Zeitsignal bzw. Taktsignal an das Rechenwerk (R) abgeben wird, dass vom Ausgang (ZA3) periodisch Zeitmarken (ZM) an eine Steuerlogik (SL) abgegeben werden und dass vom Ausgang (ZA4) ein Taktsignal an die Phasenregisterstufe (PR) abgegeben wird, dass ein Ausgang (rst) des Rechenwerks (R) mit dem Rückstelleingang der Phasenregisterstufe (PR) verbunden ist, dass die Steuerlogik (SL) über zwei Befehlsleitungen (sta, sto) und eine Statusleitung (e/a) mit dem Rechenwerk (R) verbunden ist und dass die Phasenregisterstufe (PR) über eine Befehlsleitung (ss) mit der Steuerlogik (SL) verbunden ist.

14. Direkt digitales Frequenzsynthesegerät nach einem der vorhergehenden Ansprüche 9 bis 13, **dadurch gekennzeichnet,** dass der Ausgang des Akkumulators mit einem Digital-Analog-Wandler (D/A) verbunden ist.

**Claims**

1. Method for generating periodic electrical oscillations with selectively adjustable frequency, in which the phase coherence is maintained after changing and resetting the frequency to any value already generated earlier, characterized in that periodically a time interval of $t = 0$ to $t = t_Z$ is counted, and in that the initial phase $\phi_N$ of a frequency $f_N$ to be set anew is calculated beforehand for a later counting instant $t_N$ ($0 \geq t_N \leq t_Z$) corresponding to a state of the periodically counted time interval and the frequency $f_N$ is generated from the counting instant $t_N$ with the initial phase $\phi_N$.

2. Method according to claim 1, characterized in that the initial phase $\phi_N$ is calculated with the aid of the formula $\phi_N = |2\pi\, f_N\, t_N + \phi_0|$ modulo $2\pi$, with the phase $\phi_0$ being equal for all frequencies $f_N$ to be generated anew.

3. Method according to claim 2, characterized in that to generate any frequencies $f_N$ the time interval of $t = 0$ to $t = t_Z$ to be counted is selected in such a way that the last frequency change takes place before first exceeding the counting instant $t_Z$.

4. Method according to claim 2, characterized in that after first exceeding the counting instant $t_Z$, frequencies are only generated which have a period, the integral multiple of which corresponds to the time interval of $t = 0$ to $t = t_Z$.

5. Method according to claim 3 or 4, characterized in that before the generation of an oscillation with a new frequency $f_N$ the generation of the old oscillation with the old frequency $f_A$ is discontinued at a counting instant $t_A$ ($0 \leq t_A \leq t_Z$).

6. Method according to one of the preceding claims, characterized in that time marks (ZM) are periodically generated, by means of which various counting instants (e.g. $t = 0$, $t_Z$, $t_A$ and / or $t_N$) are fixed, with the counting instant $t_A$ falling on a time mark ($ZM_1$) and the counting instant $t_N$ falling on one of the following time marks ($ZM_{(1+x)}$).

7. Method according to one of the preceding claims, characterized in that the phase $\phi_1$ of a frequency $f_1$ corresponds to the periodically incremented content of a phase register stage PR, in that after a command for frequency change the incrementing procedure is stopped at the counting instant $t_A$, in that the phase $\phi_A$ of the old frequency $f_A$ is calculated for the counting instant $t_A$ or is read from the phase register (PR), and in that the phase $\phi_N$ of the new frequency $f_N$ is calculated for the counting instant $t_N$ following later and from this the phase difference

$$\Delta\phi = \phi_{N(t_N)} - \phi_{A(t_A)}$$

and is thereafter added at a counting instant $t_R (t_A \leq t_R \leq t_N)$ to the content of the phase register stage (PR) or in that the content of the phase register stage (PR) is set at zero at a counting instant $t_R$ ($t_A \leq t_R \leq t_N$) and is increased by the amount of the calculated phase $\phi_N$ and in that the incrementing procedure is started again at the counting instant $t_N$.

8. Method according to claim 7, characterized in that the periodic counting of the time interval of $t = 0$ to $t = t_Z$ and the incrementing procedure of the phase register stage (PR) and, if present, the time marks (ZM) are temporally controlled by the same main clock pulse.

9. Directly digital frequency synthesis device for carrying out the method according to claim 1 with a main clock frequency (htf) and a phase accumulator formed from a phase incrementing stage (PI) and a phase register stage (PR), which accumulator delivers a digital output signal, characterized in that a computer (R) connected by way of control and data lines to the phase accumulator and to a time measuring unit (ZME) is provided, which calculates the initial phase $\phi_N$ of a frequency $f_N$ to be set anew for an instant $t_N$, deposits the determined value into the phase accumulator and initiates the frequency synthesis procedure at the instant $t_N$ for the frequency $f_N$ beginning with the calculated and stored initial phase $\phi_N$.

10. Directly digital frequency synthesis device according to claim 9, characterized in that the computer (R) is provided for calculating the phase difference $\Delta\phi$ between the phase $\phi_A$ present in the accumulator and the initial phase $\phi_N$ and for its delivery to the accumulator.

11. Directly digital frequency synthesis device according to claim 9, characterized in that the computer (R) is provided for resetting the accumulator and for the input of the initial phase $\phi_N$ into the accumulator.

12. Directly digital frequency synthesis device according to claim 10 or 11, characterized in that the computer (R) is provided for stopping the accumulator at an instant $t_A$ and for restarting the accumulator at an instant $t_N$.

13. Directly digital frequency synthesis device according to one of the preceding claims 9 to 12, characterized in that signals derived from the main clock frequency (htf) are delivered from the outputs (ZA1, ZA2, ZA3, ZA4) of the time measuring unit (ZME), in that a time signal or clock signal is delivered from the outputs (ZA1) and (ZA2) to the counter (R), in that time marks (ZM) are periodically delivered from the output (ZA3) to a control logic unit (SL) and in that a clock signal is delivered from the output (ZA4) to the phase register stage (PR), in that an output (rst) of the counter (R) is connected to the resetting input of the phase register stage (PR), in that the control logic unit (SL) is connected by way of two command lines (sta, sto) and a status line (e/a) to the counter (R) and in that the phase register stage (PR) is connected by way of a command line (ss) to the control logic unit (SL).

14. Directly digital frequency synthesis device according to one of the preceding claims 9 to 13, characterized in that the output of the accumulator is connected to a digital-analog converter (D/A).

**Revendications**

1. Procédé pour produire des oscillations électriques périodiques possédant une fréquence réglable à volonté, la cohérence de phase restant conservée après modification et retour de la fréquence à n'importe quelle valeur déjà produite antérieurement, caractérisé par le fait que périodiquement un intervalle de temps s'étendant de t = 0 à t = $t_Z$ est compté, et que la phase initiale $\phi_N$ d'une fréquence $f_N$, qui doit être à nouveau réglée, est calculée par avance pour un instant ultérieur de comptage $t_N$ ($0 \leq t_N \leq t_Z$), qui correspond à un état de l'intervalle de temps compté périodiquement, et que la fréquence $f_N$ de l'instant de comptage $t_N$ est produite avec la phase initiale $\phi_N$.

2. Procédé suivant la revendication 1, caractérisé par le fait que la phase initiale $\phi_N$ est calculée conformément à la formule $\phi_N = |2\pi f_N t_N + \phi_0|$ modulo $2\pi$, la phase $\phi_0$ étant la même pour toutes les fréquences $f_N$ devant être nouvellement produites.

3. Procédé suivant la revendication 2, caractérisé par le fait que pour la production de fréquences $f_N$ quelconques, l'intervalle de temps devant être compté de t = 0 à t = $t_Z$ est choisi de telle sorte que le dernier changement de fréquence s'effectue avant le premier dépassement de l'instant de comptage $t_Z$.

4. Procédé suivant la revendication 2, caractérisé par le fait qu'après le premier dépassement de l'instant de comptage $t_Z$, seules sont encore produites, des fréquences possédant une période, dont la durée correspond à un multiple entier de l'intervalle de temps s'étendant de t = 0 à t = $t_Z$.

5. Procédé suivant la revendication 3 ou 4, caractérisé par le fait qu'avant la production d'une oscillation possédant une nouvelle fréquence $f_N$, la production de l'ancienne oscillation possédant l'ancienne fréquence $f_A$ est interrompue à un instant $t_A$ ($0 \leq t_A \leq t_Z$).

6. Procédé suivant l'une des revendications précédentes, caractérisé par le fait que des marques temporelles périodiques (ZM), à l'aide desquelles sont fixés les différents instants de comptage (par exemple t = 0, $t_Z$, $t_A$ et/ou $t_N$), sont produites, l'instant de comptage $t_A$ coïncidant avec une marque temporelle (ZM$_1$) et l'instant de comptage $t_N$ avec l'une des marques temporelles suivantes (ZM$_{(1+x)}$).

7. Procédé suivant l'une des revendications précédentes, caractérisé par le fait que la phase $\phi_1$ possédant une fréquence $f_1$ correspond au contenu, incrémenté périodiquement, d'un étage formant registre de phases (PR), qu'après une instruction de changement de fréquence, le processus d'incrémentation est arrêté à l'instant de comptage $t_A$, que la phase $\phi_A$ de l'ancienne fréquence $f_A$ est calculée pour l'instant de comptage $t_A$ ou est lue à partir du registre de phases (PR), et que la phase $\phi_N$ de la nouvelle fréquence $f_N$ est calculée pour l'instant de comptage immédiatement suivant $t_N$ et qu'à partir de là la différence de phase $\Delta\phi = \phi_{N(tN)} - \phi_{A(tA)}$ est calculée, et qu'ensuite, à un instant de comptage $t_R$ ($t_A \leq t_R \leq t_N$) est ajouté au contenu de l'étage formant registre de phases (PR) ou que le contenu de l'étage formant registre de phases (PR) est positionné à zéro à un instant de comptage $t_R$ ($t_A \leq t_A \leq t_N$) et est accru de la valeur de la phase calculée $\phi_N$, et que le processus d'incrémentation redémarre à l'instant de comptage $t_N$.

8. Procédé suivant la revendication 7, caractérisé par le fait que le comptage périodique de l'intervalle de temps de t = 0 à t = $t_Z$ et l'incrémentation de l'étage formant registre de phases (PR) ainsi que, le cas échéant, les marques temporelles (ZM), sont commandés dans le temps par la même cadence principale.

9. Appareil de synthèse numérique directe de fréquences pour la mise en oeuvre du procédé suivant la revendication 1 avec une fréquence de cadence principale (htf) et un accumulateur de phase formé à partir d'un étage d'incrémentation de phase (PI) et d'un étage formant registres de phases (PR) et qui délivre un signal de sortie numérique, caractérisé par le fait qu'il est prévu un calculateur (R), qui est relié, par l'intermédiaire de lignes de commande et de lignes de transmission de données, à l'accumulateur de phase et à une minuterie (ZME) et qui calcule la phase initiale $\phi_N$ d'une fréquence $f_N$, devant être nouvellement réglée, pour un instant $t_N$, introduit la valeur déterminée dans l'accumulateur de phase et déclenche l'opération de synthèse de fréquences à l'instant $t_N$ pour la fréquence $f_N$ en commençant par la phase initiale $\phi_N$ calculée et mémorisée.

10. Appareil de synthèse numérique directe de fréquences suivant la revendication 9, caractérisé par le fait que le calculateur (N) est prévu pour le calcul de la différence de phase $\Delta\phi$

entre la phase $\phi_A$ présente dans l'accumulateur et la phase initiale $\phi_N$, ainsi que pour son envoi à l'accumulateur.

11. Appareil de synthèse numérique directe de fréquences suivant la revendication 9, caractérisé par le fait que le calculateur (R) est prévu pour ramener à l'état initial l'accumulateur et pour introduire la phase initiale $\phi_N$ dans l'accumulateur.

12. Appareil de synthèse numérique directe de fréquences suivant la revendication 10 ou 11, caractérisé par le fait que la calculateur (R) est prévu pour arrêter l'accumulateur à un instant $t_A$ et pour faire redémarrer l'accumulateur à un instant $t_N$.

13. Appareil de synthèse numérique directe de fréquences suivant l'une des revendications précédentes 9 à 12, caractérisé par le fait que les sorties (ZA1, ZA2, ZA3, ZA4) de la minuterie (ZME) délivrent des signaux qui sont dérivés de la fréquence de cadence principale (htf), que les sorties (ZA1) et (ZA2) envoient un signal de temps ou un signal de cadence à l'unité de calcul (R), que la sortie (ZA3) envoie périodiquement des marques temporelles (ZM) à l'unité logique de commande (SL) et que la sortie (ZA4) envoie un signal de cadence à l'étage formant registre de phases (PR), qu'une sortie (rst) de l'unité de calcul (P) est reliée à l'unité de remise à l'état initial de l'étage formant registre de phase (PR), que l'unité logique de commande (SL) est reliée à l'unité de calcul (R) par l'intermédiaire de deux lignes de transmission d'instructions (sta, sto) et d'une ligne de transmission d'état (e/a), et que l'étage formant registre de phases (PR) est relié à l'unité logique de commande (SL) par l'intermédiaire d'une ligne de transmission d'instructions (ss).

14. Appareil de synthèse numérique directe de fréquences suivant l'une des revendications précédentes 9 à 13, caractérisé par le fait que la sortie de l'accumulateur est reliée à un convertisseur numérique/analogique D/A.

Fig.1

Fig.2

EP 0 375 880 B1

Fig.3a

Fig.3b

11